# EUROPÄISCHE PATENTSCHRIFT

(11) **EP 0 483 679 B1**
(45) Veröffentlichungstag und Bekanntmachung des Hinweises auf die Patenterteilung: **23.08.1995**
(21) Anmeldenummer: 91118219.4
(22) Anmeldetag: 25.10.1991
(51) Int. Cl.: H01L 39/22, H01L 39/24

(54) **Supraleitendes Bauelement**
Superconducting device
Dispositif à supraconducteur

(30) Priorität: 31.10.1990 DE 4034644
(43) Veröffentlichungstag der Anmeldung: 06.05.1992
(73) Patentinhaber: FORSCHUNGSZENTRUM JÜLICH GMBH, 52425 Jülich (DE)
(72) Erfinder: Sodtke, Erik, W-5170 Jülich (DE); Xu, Yunhui, Dr., W-5170 Jülich (DE)

(56) Entgegenhaltungen:
- EP-A- 0 307 246
- EP-A- 0 364 101
- APPLIED PHYSICS LETTERS, Bd. 55, Nr. 19, 6. November 1989, New York, US, Seiten 2032-2034 ; C.T. ROGERS et al. : "Fabrication of heteroepitaxial YBa2Cu3O7-x-PrBa2Cu3O7-x-YBa2Cu3O7-x Josephson devices grown by laser deposition"

## Beschreibung

Die Erfindung bezieht sich auf ein supraleitendes Bauelement mit auf einem Substrat aufgewachsenen Schichten aus supraleitendem Material mit Kristallstruktur der Hochtemperatursupraleiter SEBa₂Cu₃O₇ (SE = seltene Erde), bei dem supraleitende Schichten mit normalleitender Barrierenschicht aus PrBa₂Cu₃O₇ abwechseln.

Derartige supraleitende Bauelemente sind aus US-Z: Appl.Phys.Lett., Bd. 55, 1989, S. 2032-2034, US-Z: Appl.Phys.Lett., Bd. 56, 1990, S. 391-393 bekannt.

In der Klasse der Materialien mit SEBa₂Cu₃O₇-Struktur (im folgenden als 123-Struktur abgekürzt) existieren sowohl supraleitende (SE = Y, Er, Eu, Nd, Gd etc.) als auch halbleitende (SE = Pr) Substanzen. Aus dünnen Schichten dieser Materialien können epitaktische Multilayer-Schichtsysteme erzeugt werden. Durch Strukturierung dieser Multilayer können kryoelektronische Bauelemente erzeugt werden, die das Verhalten von Supraleiter/Normalleiter/Supraleiter-Kontakten (SNS-Kontakte) zeigen und in denen der Josephson-Effekt auftritt. Es handelt sich hierbei um eine mögliche Realisierungsform eines Josephson-Kontaktes, um ein sog. weak link.

Josephson-Kontakte können auch als Supraleiter/Isolator/Supraleiter-Kontakt realisiert werden. Es handelt sich hierbei um einen sogenannten Tunnelkontakt. In Verbindung mit den Hochtemperatursupraleitern mit 123-Struktur wird somit ein Material mit genügend hohem spezifischen Widerstand benötigt, daß als Tunnelbarriere wirken kann. Von besonderem Interesse sind hierbei solche Materialien, die die Möglichkeit epitaktisch wachsender Multilayer-Schichtsysteme eröffnen, insbesondere jene, die dieselbe Kristallstruktur wie die 123-Supraleiter besitzen.

Um ein optimales Verhalten von SNS-Kontakte enthaltenden kryoelektronischen Bauelementen zu erreichen, ist eine Impedanzanpassung der SNS-Kontakte je nach Art des speziellen Bauelementes erforderlich, d.h. der Widerstand der normalleitenden Barrierenschicht muß einen bestimmten Wert haben. Welche Materialien mit 123-Struktur einen für diese Zwecke ausreichend großen und einstellbaren spezifischen elektrischen Widerstand haben, war bisher nicht bekannt. Den genannten Druckschriften US-Z: Appl.Phys.Lett., Bd. 55, 1989, S. 2032-2034, US-Z: Appl.Phys.Lett., Bd. 56, 1990, S. 391-393, EP 0 307 246 A2 ist nicht zu entnehmen, daß durch die Substitution von Kupfer durch Gallium in PrBa₂Cu₃O₇ verbesserte und geeignet variierbare Tunnelsperrschichten, das heißt solche mit höherem normalleitenden und einstellbaren Widerstand, ermöglicht werden.

Ziel ist ein Bauelement mit einer Barrierenschicht mit 123-Struktur, das über einem variierbaren und mit dem bekannten Ergebnissen verglichen deutlich erhöhten spezifischen elektrischen Widerstand verfügt.

Damit soll einerseits die Impedanzanpassung von SNS-Kontakten und andererseits die Herstellung von Josephson-Tunnelkontakten ermöglicht werden.

Als Ausgangsmaterial für die normalleitende Barrierenschicht wurde das halbleitende PrBa₂Cu₃O₇ gewählt. Von zentraler Bedeutung für den Stromtransport in den 123-Materialien sind die CuO₂-Ebenen und die CuO-Ketten in der kristallographischen a/b-Ebene bzw. in Richtung der b-Achse. Es wurde daher das Kupfer teilweise durch Gallium substituiert. Die dadurch eingebrachten Störungen der elektronischen Struktur der CuO₂-Ebenen und CuO-Ketten führen mit steigendem Substitutionsgrad zu einem gegenüber dem unsubstituierten Material immer stärker erhöhten elektrischen Widerstand. Mit sinkender Temperatur wird dieser Effekt bei einem bestimmten Substitutionsgrad wesentlich ausgeprägter. Insbesondere liefert die normalleitende Barrierenschicht aus PrBa₂Cu₃₋ₓGaₓO₇ mit 0,0<x<0,7 geeignet hohe und varriierbare spezifische elektrische Widerstände.

### Ausführungsbeispiel

Bei dünnen Schichten mit der Zusammensetzung PrBa₂Cu_{2,9}Ga_{0,1}O₇ wurde der spezifische Widerstand gegenüber dem unsubstituierten Material bei einer Temperatur von 90 Kelvin um den Faktor 300 erhöht, bei einer Temperatur von 77 Kelvin um den Faktor 1000. Diese Temperaturen markieren die obere Grenze des Betriebsbereiches von supraleitenden Bauelementen mit 123-Supraleitern. In diesem Bereich kann bereits mit geringen Gallium-Substitutionen eine Steigerung des elektrischen Widerstandes um zwei bis drei Größenordnungen erreicht werden.

Für die Verbindungen PrBa₂Cu_{2,7}Ga_{0,3}O₇ bzw. PrBa₂Cu_{2,3}Ga_{0,7}O₇ steigt der spezifische Widerstand bei 77 Kelvin um den Faktor 2x10⁵ bzw. 5x10⁶ gegenüber dem unsubstituierten Material an.

Durch Variation von x in PrBa₂Cu₃₋ₓGaₓO₇ zwischen 0,0 und 0,7 läßt sich somit der spezifische elektrische Widerstand bei 77 Kelvin um bis zu sechs Größenordnungen steigern.

Die Steigerung des spezifischen Widerstandes und die Einphasigkeit des Materials wurden mit Hilfe von elektrischer Vierpunktmessung, Röntgenbeugung und Raman-Spektroskopie überprüft.

## Patentansprüche

1. Supraleitendes Bauelement mit auf einem Substrat aufgewachsenen Schichten aus supraleitendem Material mit Kristallstruktur der Hochtemperatursupraleiter SEBa₂Cu₃O₇ (SE = seltene Erde), bei dem supraleitende Schichten mit normalleitender Barrierenschicht aus PrBa₂Cu₃O₇ abwechseln,
**dadurch gekennzeichnet,**
daß bei der normalleitenden Barrierenschicht zusätzlich Cu teilweise durch Gallium substituiert ist.

2. Supraleitendes Bauelement nach Anspruch 1,
**dadurch gekennzeichnet,**
daß die normalleitende Barrierenschicht aus PrBa₂Cu₃₋ₓGaₓO₇ mit 0,0 < x < 0,7 besteht.

## Claims

1. A superconducting component having layers of superconducting material with the crystal structure of the high-temperature superconductor REBa₂Cu₃O₇ (RE = rare earth) grown on a substrate, wherein the superconducting layers alternate with normally conducting barrier layers of PrBa₂Cu₃O₇, characterised in that in addition Cu is partially replaced by gallium in the normally conducting barrier layer.

2. A superconducting component according to claim 1, characterised in that the normally conducting barrier layer consists of PrBa₂Cu₃₋ₓGaₓO₇, where 0.0 < x < 0.7.

## Revendications

1. Composant supraconducteur ayant des couches en matière supraconductrice que l'on a fait croître sur un substrat et qui ont la structure cristalline du supraconducteur à haute température SEBa₂Cu₃O₇ (SE = terre rare), dans lequel des couches supraconductrices alternent avec une couche barrière normalement conductrice en PrBa₂Cu₃O₇, caractérisé en ce que dans la couche barrière normalement conductrice du Cu est remplacé en plus en partie par du gallium.

2. Composant supraconducteur suivant la revendication 1, caractérisé en ce que la couche barrière normalement conductrice est en PrBa₂Cu₃₋ₓGaₓO₇ avec 0,0 < x < 0,7.
